# EUROPEAN PATENT APPLICATION

(11) **EP 2 487 509 A1**
(43) Date of publication of application: **15.08.2012**
(21) Application number: 09850207.3
(22) Date of filing: 05.10.2009
(51) Int. Cl.: G01T 1/24, H01L 27/14

(54) **RADIATION DETECTOR**

(71) Applicant: Shimadzu Corporation, Kyoto 604-8511 (JP)
(72) Inventor: SATO, Kenji, Kyoto-shi Kyoto 604-8511 (JP); TSUJI, Hisao, Kyoto-shi Kyoto 604-8511 (JP); SASAKI, Osamu, Kyoto-shi Kyoto 604-8511 (JP); MURAKAMI, Daisuke, Kyoto-shi Kyoto 604-8511 (JP); YAMAGUCHI, Yoichi, Kyoto-shi Kyoto 604-8511 (JP); YAMAMOTO, Takeshi, Kyoto-shi Kyoto 604-8511 (JP); KISHIMOTO, Hidetoshi, Kyoto-shi Kyoto 604-8511 (JP)
(74) Representative: Wilhelms · Kilian & Partner Patentanwälte
(86) International application number: PCT/JP2009/005163
(87) International publication number: WO 2011/042930

(57) **Abstract**

A radiation detector 1 of this invention has a barrier layer 27 on the upper surface of a high resistance film 7 along the outer edge of a common electrode 5, which enables prevention of a chemical reaction between an amorphous semiconductor layer 9 and a curable synthetic resin 29. The barrier layer 27 is adhesive to the curable synthetic resin film 29, and this can prevent strength being insufficient, such that temperature changes cause separation in interfaces between the barrier layer 27 and curable synthetic resin film 29, thereby reducing the effect of inhibiting warpage and cracking. The material for the barrier layer 27 is an insulating material not including a substance that would chemically react with the amorphous semiconductor layer 9. This can prevent components of the material for the barrier layer 27 from chemically reacting with the semiconductor layer. Consequently, creeping discharge at the outer edge of the common electrode 5 where electric fields concentrate can be prevented.

## Description

### [TECHNICAL FIELD]

This invention relates to a radiation detector for industrial or medical use, and more particularly to a construction of a radiation detector which converts radiation directly into carriers.

### [BACKGROUND ART]

A conventional radiation detector of the direct conversion type is constructed to apply a predetermined bias voltage to a common electrode formed on a front surface of a radiation sensitive semiconductor layer, collect carriers generated by emission of radiation (X-rays or the like) in carrier collecting electrodes formed on a back surface of the semiconductor layer, and take them out as radiation detection signals, thereby to detect the radiation.

Particularly where an amorphous semiconductor layer such as a-Se (amorphous selenium) is used as the semiconductor layer, the amorphous semiconductor can be formed easily into a thick and large layer by a method such as vacuum vapor deposition. Therefore, it is suitable for constructing a two-dimensional array type radiation detector needing a large-area and thick layer.

However, such conventional direct conversion type radiation detector, since a high voltage is applied to the common electrode for use, has a problem caused by discharge phenomenon, particularly a problem of creeping discharge occurring easily. Creeping discharge is a phenomenon in which current flows from the common electrode to which the high voltage is applied, along a surface such as of the semiconductor layer, to a matrix substrate having various wires, elements and so on formed thereon. This inflicts damage on the radiation detector, and becomes a cause of shortening the product's life such as by lowering radiation detecting accuracy.

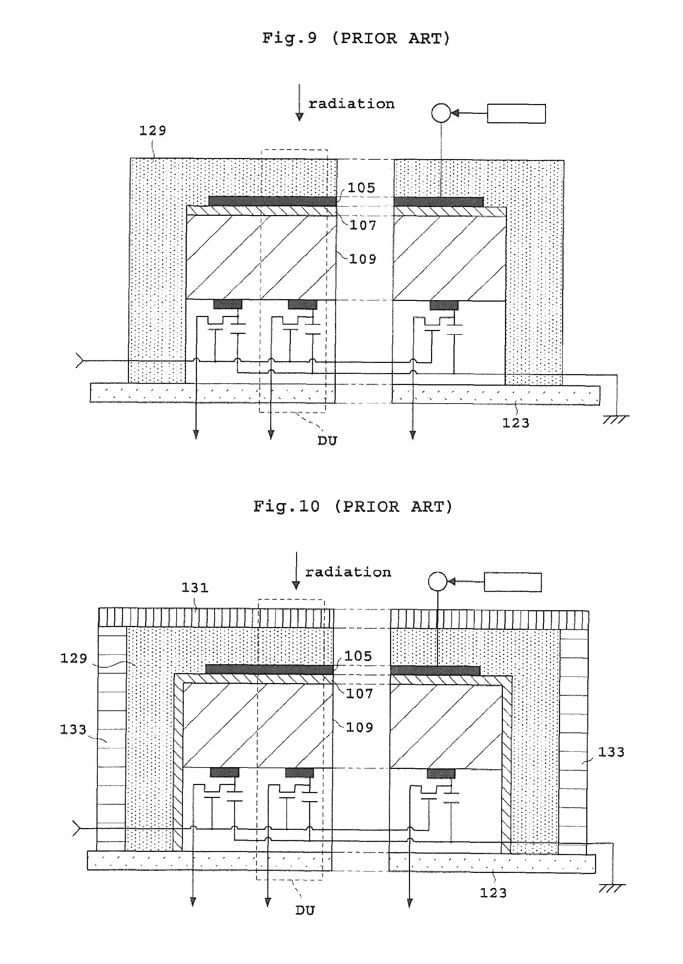

In Patent Document 1, a radiation detector has been proposed, which is constructed such that, as shown in Fig. 9, in order to inhibit creeping discharge, a curable synthetic resin film 129 of silicone resin, which is a high resistance insulating layer, covers entire surfaces of a common electrode 105, a carrier selective high resistance film 107 and an amorphous semiconductor layer 109. With this construction, however, temperature change will cause warpage of the radiation detector due to differences in thermal expansion coefficient. Consequently, cracks will be formed in the common electrode 105, high resistance film 107, amorphous semiconductor layer 109 and curable synthetic resin film 129 of silicone resin, and a creeping discharge voltage resistance will become insufficient.

So, in Patent Document 2, a construction for inhibiting warpage of the radiation detector has been proposed (Fig. 10), in which an insulating auxiliary plate 131 with a thermal expansion coefficient comparable to that of an insulating substrate 123 is fixed in a position opposed to the insulating substrate 123 across the curable synthetic resin film 129. A similar construction has been proposed in Patent Document 3 also.

In Patent Document 3, a further proposal has been made to use a silane compound for the curable synthetic resin film 129 formed between the insulating substrate 123 on which the amorphous semiconductor layer 109 and the like are formed, and the auxiliary plate 131. This can make the thermal expansion coefficient of the curable synthetic resin film 129 comparable to that of the insulating substrate 131, thereby to inhibit warpage and cracking.

However, since the amorphous semiconductor 109 such as of a-Se which is optimal for large area formation has a low glass transition temperature (that is, vulnerable to heat), the curable synthetic resin 129 of the type curable by heating cannot be used. There is a restriction that a curable synthetic resin of the type curable at normal temperature must be used. Patent Document 2 describes that an epoxy resin is used as the curable synthetic resin 129 which cures at normal temperature below 40°C, and that the epoxy resin contains components having a relatively low reactivity with the amorphous semiconductor film 109. Further, in order to prevent a chemical reaction between the epoxy resin and amorphous semiconductor film 109, a construction has been proposed in which a solvent resistant and carrier selective high resistance film 107 such as Sb₂S₃ film is sandwiched between the common electrode 105 and amorphous semiconductor layers 109.

In Patent Document 4, a radiation detector has been proposed which uses an organic layer of polycarbonate mixed with a hole moving agent as what has an effect similar to the Sb₂S₃ film.

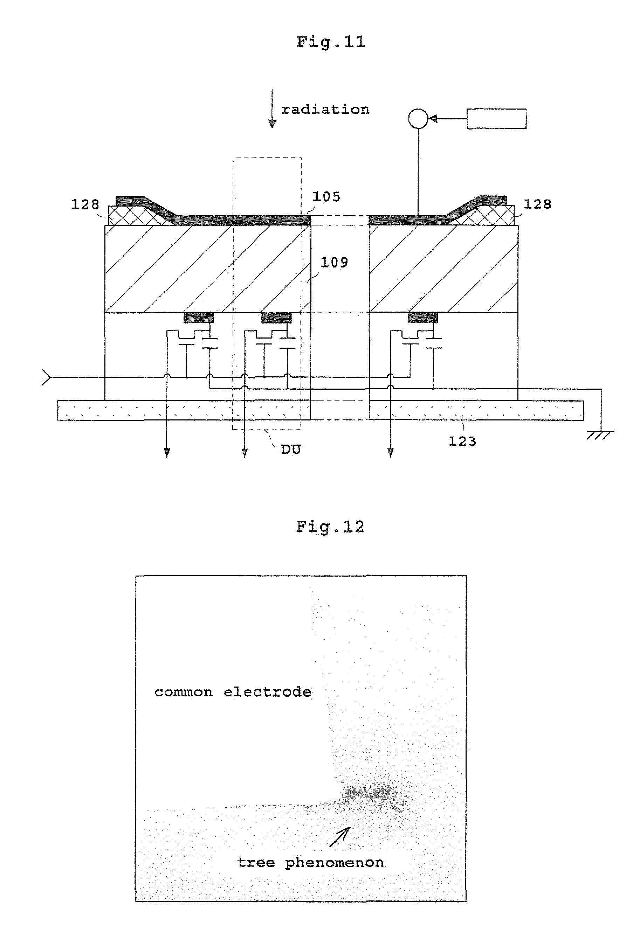

In Patent Document 5, a proposal has been made which, as shown in Fig. 11, a high resistance insulating material 128 is formed between an outer edge of the common electrode 105 and amorphous semiconductor layer 109, to prevent penetrating discharge and creeping discharge due to electric field concentrations at the outer edge of the common electrode 105. Cited as examples of high resistance insulating material 128 are insulating resins, such as silicone resin, epoxy resin, acrylic resin and fluororesin, which are materials of the type having minor chemical reaction between the components of the insulating material 128 and the amorphous semiconductor layer 109 and curable at normal temperature. There is a description that the formation thickness of these insulating materials 128 is dependent on a bias voltage needed, and that a large thickness is required if the bias voltage is high. It should be noted that, in Figs. 9 to 11 and 13, like components are affixed with like reference signs.
[Patent Document 1]
   Unexamined Patent Publication No. 2002-9268
[Patent Document 2]
   Unexamined Patent Publication No. 2002-311144
[Patent Document 3]
   Unexamined Patent Publication No. 2002-116259
[Patent Document 4]
   Unexamined Patent Publication No. 2000-230981
[Patent Document 5]
   Unexamined Patent Publication No. 2003-133575

### [DISCLOSURE OF THE INVENTION]

### [PROBLEM TO BE SOLVED BY THE INVENTION]

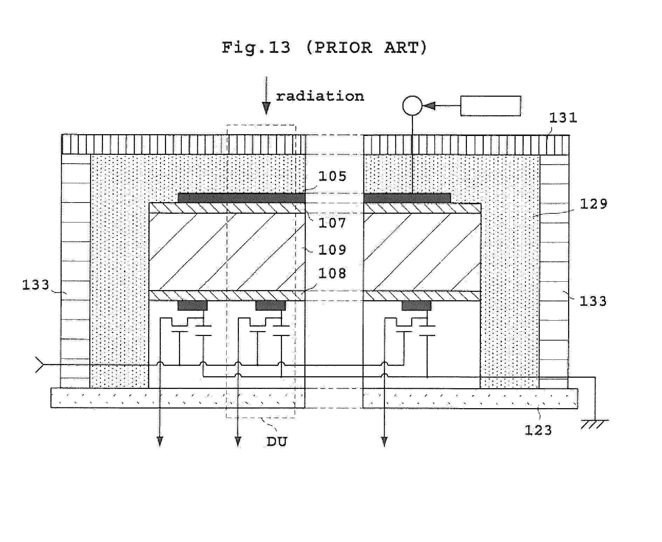

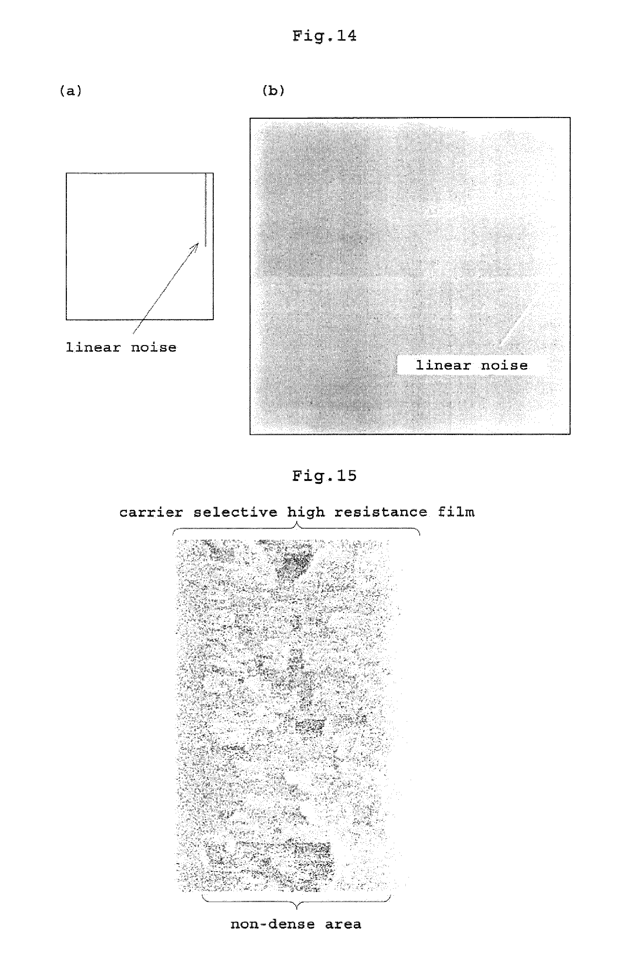

However, a new problem not disclosed in the above patent documents has been found. It is that, as shown in Fig. 10, although the entire surface of the amorphous semiconductor layer 109 is covered by the solvent resistant and carrier selective high resistance film 107, the a-Se of the amorphous semiconductor layer chemically reacts with the components of the epoxy resin which is the curable synthetic resin film. Although this reaction is relatively minor, the amorphous semiconductor layer 109 will crystallize to lower a surface resistance value when placed under high voltage for a long time. A tree phenomenon which is a sign of creeping discharge will occur particularly at an outer edge of the common electrode 105 where electric fields concentrate. Fig. 12 is an optical micrograph of a common electrode outer edge after conducting an acceleration test of a radiation detector having a construction in Fig. 13 under conditions of 40°C and 14kV. It shows a way a tree which is a resin's discharge mark has grown from an outer edge of the common electrode 105. When the tree grows and a creeping discharge takes place, a linear noise as shown in Fig. 14 will occur adjacent the discharge location. In the portion where this linear noise is generated, detection accuracy will lower remarkably.

Fig. 14 is an image detected by each detecting element with a bias voltage applied to the common electrode 105 and without emitting radiation. The radiation detector shown in Fig. 13 is for use in acceleration tests, and is constructed of a carrier selective high resistance film 108, an amorphous semiconductor layer 109, a carrier selective high resistance film 107 and a common electrode 105 formed in order on an insulating substrate 123 having wiring, elements and so on formed thereon. And a curable synthetic resin 129 is injected into a space surrounded by the insulating substrate 123, auxiliary plate 131 and spacers 133, to cover the entire exposed surfaces of the amorphous semiconductor layer 109, high resistance films 107, 108 and common electrode 105.

The silane compound of Patent Document 3, although comparable in thermal expansion coefficient to the glass substrate serving as the insulating substrate 123, is required to have a thickness of at least several millimeters and a crosslink formation by perfect hydrolysis reaction in order to secure a strength for withstanding thermal expansion and contraction of the a-Se semiconductor layer. However, in order to obtain coating film on the large area semiconductor layer, it is necessary to dissolve it in an organic solvent halfway through the crosslinking reaction. This lowers concentration of the silane compound so that sufficient strength cannot be acquired. In order to acquire strength, it is necessary to volatilize the organic solvent completely to form a high-concentration thick film after coating, and it must be heated at least to 40°C and up to 80°C. Although curing of the silane compound is promoted by this heating, a problem of the a-Se semiconductor layer crystallizing from an amorphous state has arisen. That is, since an amorphous semiconductor like a-Se has a low glass transition temperature, the curable synthetic resin film 129 which cures at normal temperature below 40°C must be selected.

As in Patent Document 5, in order to ease the electric field concentration at the outer edge of the common electrode 105 to prevent the discharge phenomenon, a construction has been proposed which has insulating material 128 formed under the outer edge of the common electrode 105, to give an elevation angle to the outer edge of the common electrode 105 (Fig. 11). It has been proved that theoretically electric fields become infinite at triple points where the common electrode 105, amorphous semiconductor layer 109 and high resistance insulating material 128 are all in contact, when the amorphous semiconductor layer 109 and high resistance insulating material 128 have different dielectric constants. When the amorphous semiconductor layer 109 is a-Se, the dielectric constant is 6 - 7. Since the dielectric constants of all the insulating materials cited in Patent Document 5 are 2 - 6, the electric fields at the triple points become large, and conversely, it is imagined that an increase in dark current and a penetrating discharge phenomenon will occur.

This invention has been made having regard to the state of the art noted above, and its object is to provide a radiation detector which can prevent creeping discharge generating from a common electrode outer edge.

### [MEANS FOR SOLVING THE PROBLEM]

Inventor herein has made intensive research and attained the following findings. First, in order to determine what material chemically reacts with a-Se to reduce its resistance, a-Se and a mixture of the base resin and the curing agent of an epoxy resin were sealed so that the two would not contact each other, and were left standing at 40°C for ten days. Then, it has been found that the a-Se surface is crystallized by volatile components from the epoxy resin. The volatile components were analyzed by gas chromatography, and several types of reagent consisting of separated gas components were dripped on the a-Se to compare crystallization states. The results showed that an amine-based reagent intensely crystallized the a-Se. Since a-Se will become lower in resistance when it crystallizes, it has been found from the above experimental results that the component which lowers the resistance of a-Se, among the components of the epoxy resin is an amine compound.

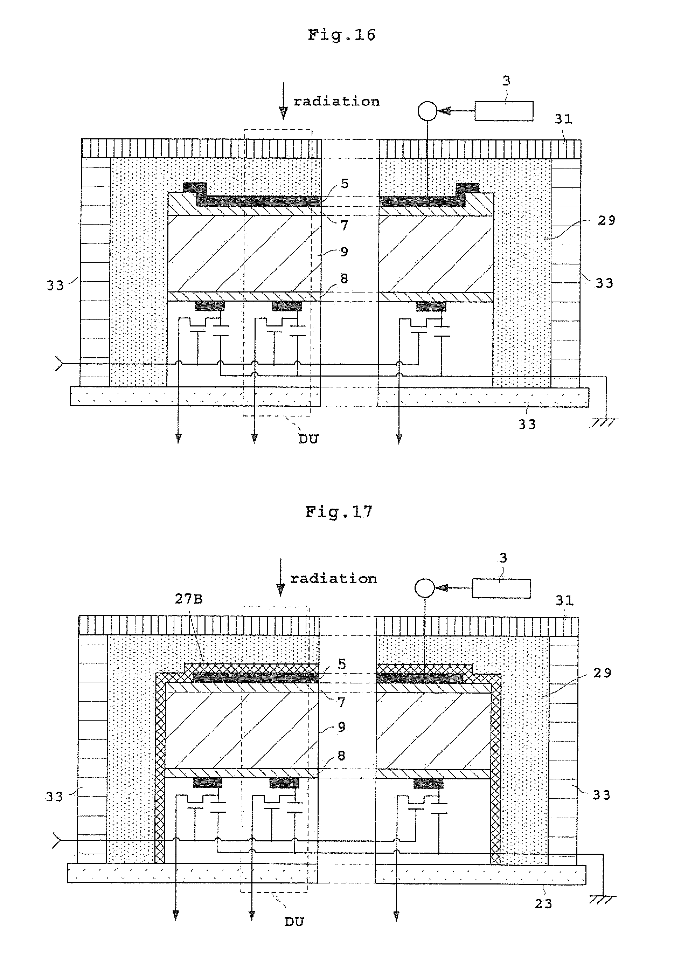

It has also been found that, although, as shown in Fig. 10, the entire surface of the amorphous semiconductor layer 109 is covered by the carrier selective high resistance film 107, the cause of the amorphous semiconductor layer 109 chemically reacting with the component of the epoxy resin is attributable to the fact that the carrier selective high resistance film 107 is not a completely dense film as shown in Fig. 15. Fig. 15 is an electron micrograph of a section of the carrier selective high resistance film 107. It has been found from this micrograph that there is a non-dense area inside the carrier selective high resistance film 107. In order to eliminate the influence of this incomplete density of the carrier selective high resistance film 107 and to prevent penetration of the component, the thickness of the carrier selective high resistance film 107 must be increased. However, the greater thickness will result in the lower mobility of carriers, and radiation detection sensitivity will fall especially when it exceeds several micrometers. Thus, there is a limit to increasing the thickness of the carrier selective high resistance film 107. It is conceivable, therefore, as shown in Fig. 16, to increase only the thickness of the common electrode outer edge where electric fields concentrate, but such formation is difficult. Then, it has been found out that a new barrier layer may be formed around the outer edge of the common electrode 105 where electric fields concentrate.

The silicone resin described in Patent Document 1, which is formed for prevention of creeping discharge, although also effective to prevent a chemical reaction between the amorphous semiconductor layer and the component of an epoxy resin which is the curable synthetic resin film, has a problem of being little adhesive to the epoxy resin, to reduce the effect of inhibiting warpage and cracking due to temperature change. Therefore, a barrier layer to be formed is subject to a selection condition that it has good adhesiveness to the curable synthetic resin film. A barrier layer that does not chemically react with a-Se and can be formed at normal temperature below 40°C should be selected.

Applicant herein has proposed inventions shown in International Patent applications PCT/JP2008/056945 and PCT/JP2009/001611, prior to this invention. That is, radiation detectors with a construction as shown in Fig. 17 have been proposed, in which a barrier layer 27B not including an amine compound is formed between exposed surfaces of an amorphous semiconductor layer 9, carrier selective high resistance films 7 and 8 and a common electrode 5 formed on an insulating substrate 23, and a curable synthetic resin film. Figs. 16 and 17 have like reference signs affixed to like components which are the same in each embodiment to be described hereinafter.

This invention has been made based on the above findings, and provides the following construction to fulfill its object. A radiation detector according to this invention comprises (a) a radiation sensitive semiconductor layer for generating carriers upon incidence of radiation; (b) a high resistance film formed to cover an upper surface of the semiconductor layer for selecting and transmitting the carriers; (c) a common electrode formed on an upper surface of the high resistance film for applying a bias voltage to the high resistance film and the semiconductor layer; (d) a matrix substrate formed on a lower surface of the semiconductor layer for storing and reading, on a pixel-by-pixel basis, the carriers generated in the semiconductor layer; (e) a curable synthetic resin film covering entire surfaces of the semiconductor layer, the high resistance film and the common electrode formed on an upper surface of the matrix substrate; (f) an insulating auxiliary plate disposed opposite the matrix substrate across the curable synthetic resin film, and having a thermal expansion coefficient comparable to that of the matrix substrate; and (g) a barrier layer formed of an insulating material, which is formed on the upper surface of the high resistance film along an outer edge of the common electrode, prevents a chemical reaction between the semiconductor layer and the curable synthetic resin film, is adhesive to the curable synthetic resin film, and does not chemically react with the semiconductor layer.

The radiation detector according to this invention has a barrier layer on the upper surface of the high resistance film along the outer edge of the common electrode, which enables prevention of a chemical reaction between the semiconductor layer and curable synthetic resin. The barrier layer is adhesive to the curable synthetic resin film, and this can prevent strength being insufficient, such that temperature changes cause separation at interfaces between the barrier layer and curable synthetic resin film, thereby reducing the effect of inhibiting warpage and cracking. The material for the barrier layer is an insulating material not including a substance that would chemically react with the semiconductor layer. This can prevent components of the material for the barrier layer from chemically reacting with the semiconductor layer. Consequently, creeping discharge at the outer edge of the common electrode where electric fields concentrate can be prevented.

By forming the barrier layer on the upper surface of the high resistance film along the outer edge of the common electrode, a discharge phenomenon such as creeping discharge can be prevented as with the construction having a barrier layer over entire exposed surfaces of the semiconductor layer, high resistance film and common electrode. However, since the barrier layer is not formed over the entire exposed surfaces of the semiconductor layer, high resistance film and common electrode, the barrier layer can be formed easily, and the material cost of the barrier layer can be held down.

In the radiation detector according to this invention, it is preferred that the common electrode is shaped polygonal, and the barrier layer is formed on upper surfaces of areas limited to portions around vertexes of the common electrode, of areas of formation on the upper surface of the high resistance film along the outer edge of the common electrode. When the common electrode is polygonal, the greater part of discharge phenomenon such as creeping discharge can be inhibited by forming the barrier layer only in the vertex portions where electric fields concentrate. The barrier layer can be formed more easily, and the material cost of the barrier layer can be further held down.

In the radiation detector according to this invention, it is preferred that the matrix substrate is an active matrix substrate having picture electrodes for collecting, on a pixel-by-pixel basis, the carriers generated in the semiconductor layer, capacitors for storing charges corresponding to the number of carriers collected by the picture electrodes, switching elements for reading the charges stored, and charge wires arranged in a grid pattern and connected to the switching elements arranged at respective grid points. This enables manufacture of a radiation detector subject to little influence of crosstalk though it has a large screen.

In the radiation detector according to this invention, it is preferred that the semiconductor layer is amorphous selenium. This enables manufacture of a radiation detector with a large area. Preferably, the curable synthetic resin film is an epoxy resin. Consequently, since adhesiveness to the auxiliary plate is good, there is no possibility of separation at surfaces of adhesion. Since the epoxy resin has a high degree of hardness, there is little possibility of warpage and cracking due to temperature changes.

In the radiation detector according to this invention, it is preferred that the barrier layer is thicker than the high resistance film, and an upper limit thereof is 500µm or less. When the barrier layer is thin, the components of the curable synthetic resin film will permeate, and the barrier layer will fail to function to prevent the components of the curable synthetic resin film from reacting with the semiconductor layer. When the barrier layer is thicker than 500µm, it can prevent cracking occurring in the high resistance film, for example, under the influence of thermal expansion stress of the barrier layer due to temperature changes.

In the radiation detector according to this invention, it is preferred that the barrier layer is a non-amine synthetic resin not including an amine material. This can prevent the components of the barrier layer itself from reacting with the semiconductor layer to lower the surface resistance value of the upper surface of the semiconductor layer. Preferably, the barrier layer is a non-amine synthetic resin formed at a temperature below 40°C. This can prevent the semiconductor layer from crystallizing and becoming lower in resistance due to the heat occurring at the time of forming the barrier layer.

In the radiation detector according to this invention, it is preferred that the non-amine synthetic resin is one of an acrylic resin, a polyurethane resin, a polycarbonate resin and synthetic rubber dissolved in a non-amine solvent, and is formed by volatilizing the non-amine solvent at normal temperature. Preferably, the non-amine solvent includes at least one of toluene, butyl acetate, methyl ethyl ketone, hexahydrotoluene, ethyl cyclohexane, xylene and dichlorobenzene.

In the radiation detector according to this invention, it is preferred that the barrier layer is a photo-curable resin, and is formed by being cured by light irradiation. This can achieve curing without heating, and formation can be attained in a shortened curing time.

In the radiation detector according to this invention, it is preferred that the barrier layer is formed by coating the non-amine synthetic resin by vacuum deposition method. One example of the non-amine synthetic resin coated by vacuum deposition method is poly-para-xylylene.

### [EFFECTS OF THE INVENTION]

The radiation detector according to this invention has a barrier layer on the upper surface of the high resistance film along the outer edge of the common electrode, which enables prevention of a chemical reaction between the semiconductor layer and curable synthetic resin. The barrier layer is adhesive to the curable synthetic resin film, and this can prevent strength being insufficient, such that temperature changes cause separation in interfaces between the barrier layer and curable synthetic resin film, thereby reducing the effect of inhibiting warpage and cracking. The material for the barrier layer is an insulating material not including a substance that would chemically react with the semiconductor layer. This can prevent components of the material for the barrier layer from chemically reacting with the semiconductor layer. Consequently, creeping discharge at the outer edge of the common electrode where electric fields concentrate can be prevented.

### [BRIEF DESCRIPTION OF THE DRAWINGS]

Fig. 1 is a schematic view in vertical section showing a construction of a radiation detector according to Embodiment 1;
Fig. 2 is a circuit diagram showing a construction of an active matrix substrate and peripheral circuits according to Embodiment 1;
Fig. 3 is a schematic plan view showing the construction of the radiation detector according to Embodiment 1;
Fig. 4 is a photograph showing generation of trees after an acceleration test at an Au electrode outer edge of a conventional radiation detector shown in Fig. 13;
Fig. 5 is a photograph showing a difference in occurrence of a tree phenomenon due to presence or absence of a barrier layer after the acceleration test;
Fig. 6 is a schematic plan view showing a construction of a radiation detector according to Embodiment 2;
Fig. 7 is a photograph showing generation of trees three days after an acceleration test in the conventional radiation detector shown in Fig. 13;
Fig. 8 is a photograph showing generation of trees 20 days after the acceleration test in the conventional radiation detector shown in Fig. 13;
Fig. 9 is a schematic view in vertical section showing a construction of a radiation detector in the prior art;
Fig. 10 is a schematic view in vertical section showing a construction of a radiation detector in the prior art;
Fig. 11 is a schematic view in vertical section showing a construction of a radiation detector in the prior art;
Fig. 12 is a photograph showing a tree phenomenon which is an arboroid discharge mark growing from a common electrode outer edge;
Fig. 13 is a schematic view in vertical section showing the construction of the conventional radiation detector used in the acceleration tests;
Fig. 14 shows a linear noise generating from a creeping discharge, in which (a) is a schematic view, and (b) is a photograph;
Fig. 15 is a photograph showing that a carrier selective high resistance film has a non-dense area;
Fig. 16 is a schematic view in vertical section showing a construction of a radiation detector which provides a thickness for carrier selective high resistance film portions outside a common electrode; and
Fig. 17 is a schematic view in vertical section showing a construction of a radiation detector described in International Patent Applications PCT/JP2008/056945 and PCT/JP2009/001611.

### [Description of References]

- 1, 1A: radiation detectors
- 5: common electrode
- 7, 8: high resistance films
- 9: amorphous semiconductor layer
- 23: insulating substrate
- 25: active matrix substrate
- 27, 27A: barrier layers
- 29: curable synthetic resin film
- 31: auxiliary plate

### [EMBODIMENT 1]

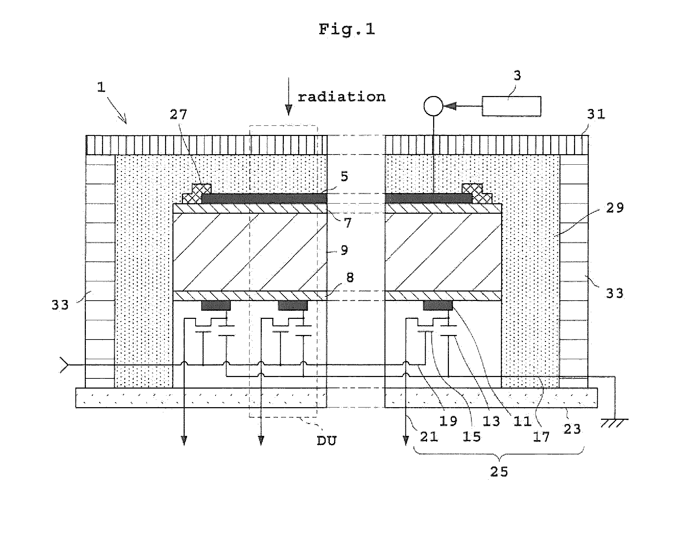

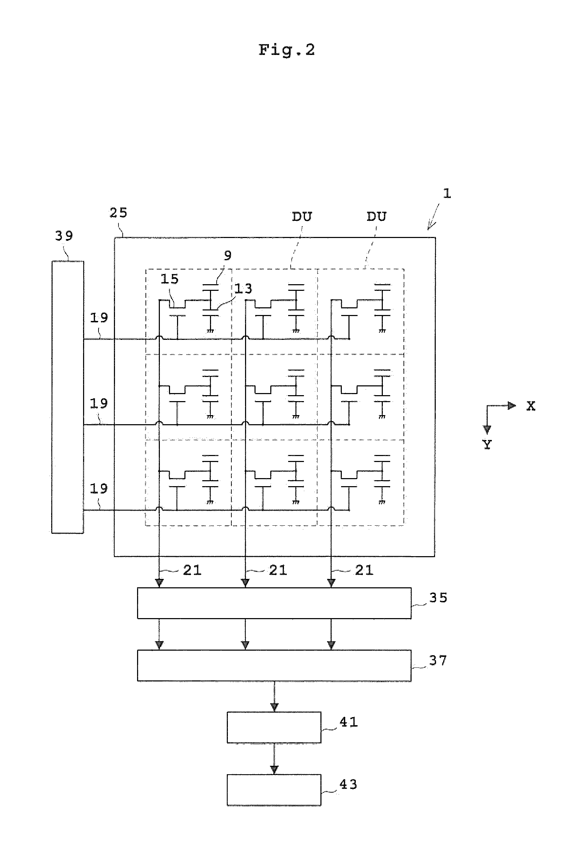

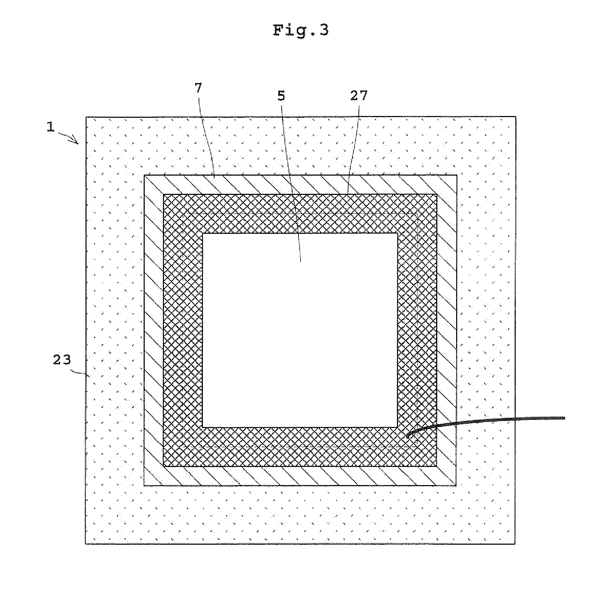

Embodiment 1 of this invention will be described hereinafter with reference to the drawings. Fig. 1 is a schematic view in vertical section showing a construction of a radiation detector. Fig. 2 is a circuit diagram showing a construction of an active matrix substrate and peripheral circuits. Fig. 3 is a schematic plan view showing the construction of the radiation detector. For expediency of description, Fig. 3 gives an illustration omitting an auxiliary plate, a curable synthetic resin film and a spacer.

### <<Radiation Detector>>

Reference is made to Fig. 1. A radiation detector 1 in this embodiment has, formed under a common electrode 5 to which a bias voltage is applied from a bias source supply 3, a carrier selective high resistance film 7 which selects and transmits carriers, and formed still thereunder is an amorphous semiconductor layer 9 which generates carriers upon incidence of radiation. That is, as a bias voltage is applied to the common electrode 5, the bias voltage is applied to the carrier selective high resistance film 7 and amorphous semiconductor layer 9. And a carrier selective high resistance film 7 is again formed under the amorphous semiconductor layer 9. Formed further thereunder is an active matrix substrate 25 which includes picture electrodes 11 for collecting the carriers on a pixel-by-pixel basis, carrier storage capacitors 13 for storing the carriers collected by the picture electrodes 11, switching elements 15 and ground lines 17 electrically connected to the carrier storage capacitors 13, gate lines 19 for sending signals for switching action to the switching elements 15, data lines 21 for reading, through the switching elements 15, electric charges stored in the carrier storage capacitors 13, and an insulating substrate 23 for supporting these components. The carriers generated in the amorphous semiconductor layer 19 can be read on a pixel-by-pixel basis by this active matrix substrate 25.

The amorphous semiconductor layer 9 corresponds to the radiation sensitive semiconductor layer in this invention. The carrier selective high resistance film 7 corresponds to the high resistance film in this invention. The gate lines 19 and data lines 21 correspond to the electrode wires in this invention. The active matrix substrate 25 corresponds to the matrix substrate in this invention.

And a barrier layer 27 is formed along outer edges of the common electrode 5 and at least on an upper surface of the carrier selective high resistance film 7. A curable synthetic resin film 29 is formed to cover the common electrode 5, carrier selective high resistance films 7, 8, amorphous semiconductor layer 9 and barrier layer 27. Further, an insulating auxiliary plate 31 is formed on an upper surface of the curable synthetic resin film 29. That is, the insulating auxiliary plate 31 is disposed opposite the active matrix substrate 25 across the curable synthetic resin film 29. The barrier layer 27 will be described in detail hereinafter.

The amorphous semiconductor layer 9 is a high purity a-Se thick film with a specific resistance of 10⁹Ωcm or more (preferably, 10¹¹Ωcm or more), and a thickness of 0.5mm to 1.5mm. This a-Se thick film can facilitate enlargement of a detecting area. If the amorphous semiconductor layer 9 were thin, radiation would be transmitted without being converted. Thus, a somewhat thick film of 0.5mm to 1.5mm is used.

The common electrode 5 and picture electrodes 11 are formed of metal, such as Au, Pt, Ni, Al, Ta or In, or ITO. Of course, the material for the amorphous semiconductor layer 9 and the material for the electrodes are not limited to the examples given above.

The carrier selective high resistance film 7 is dependent on whether the bias voltage applied to the common electrode 5 is a positive bias or a negative bias. A film with high hole injection blocking power is employed in the case of a positive bias, and a film with high electron injection blocking power in the case of a negative bias. Generally, when used for a positive bias, an N-type (the majority carriers being electrons) selective film is used as the carrier selective high resistance film 7. When used for a negative bias, a P-type (the majority carriers being holes) selection is used as the carrier selective high resistance film 7. However, since the general rule may not necessarily be valid in a high resistance domain of 10⁹Ωcm or more, it can be effective to use, for a positive bias, a Sb₂Te₃, Sb₂S₃ or ZnTe film exemplifying a P-type layer. An N-type layer is exemplified by a CdS or ZnS film. The specific resistance of the high resistance film 7, preferably, is 10⁹Ωcm or more. An appropriate thickness of the high resistance film 5 is 0.1µm to 5µm.

The auxiliary plate 31, preferably, has a thermal expansion coefficient comparable to that of the insulating substrate 23 and has a high radiation transmittance, and quartz glass is used, for example. An appropriate thickness thereof is 0.5mm to 1.5mm. As long as it is formed to prevent warping of the amorphous semiconductor layer 9, the auxiliary plate 31 is not limited to the above embodiment, but may be embodied in any form.

In this embodiment, an epoxy resin is employed as the curable synthetic resin film 29 of high withstand voltage. An epoxy resin has a high degree of hardness, and also is highly adhesive to the auxiliary plate 31. When curing the epoxy resin, it can be cured at normal temperature below 40°C and will never crystallize a-Se. When a different resin is selected as the curable synthetic resin film 29, an upper limit of curing temperature is determined by the type of semiconductor employed as the semiconductor layer. When a-Se is used as noted above, since a-Se is easily crystallized by heat, it is necessary to select a synthetic resin of the type that cures at normal temperature below 40°C.

The formation thickness of these curable synthetic resin films 29, considering that, when it is too thin, the withstand voltage will lower, and when too thick, incident radiation will attenuate, is selected to provide a gap of 1mm to 5mm, preferably 2mm to 4mm, between the insulating substrate 23 and auxiliary plate 12. In order to form this gap reliably, a spacer 33 formed of ABS resin is provided peripherally of the insulating substrate 23. The gap can be adjusted by providing the spacer 33 between the auxiliary plate 31 and active matrix substrate 25 in this way.

Numerous picture electrodes 11 are formed in a two-dimensional array, one carrier storage capacitor 13 is provided for storing carriers collected by each picture electrode 11, and one switching element 15 for reading the carriers. Thus, the radiation detector 1 in this embodiment serves as a flat panel radiation sensor of two-dimensional array construction with numerous detecting elements DU which are radiation detection pixels arranged along X- and Y-directions (see Fig. 2). This allows local radiation detection to be made for each radiation detection pixel, thereby enabling measurement of a two-dimensional distribution of radiation intensities.

The gates of thin-film transistors which cause switching of the switching elements 15 of the detecting elements DU are connected to the gate lines 19 in the horizontal (X) direction, while the drains are connected to the data lines 21 in the vertical (Y) direction.

And, as shown in Fig. 2, the data lines 21 are connected to a multiplexer 37 through a charge-voltage converter group 35. The gate lines 19 are connected to a gate driver 39. The detecting elements DU of the radiation sensor are identified based on addresses assigned to the respective detecting elements DU in order along the arrangements in the X- and Y-directions. Therefore, scan signals for signal fetching serve as signals designating the addresses in the X-direction or the addresses in the Y-direction, respectively. Although Fig. 2 shows a matrix construction for 3x3 pixels for expediency of illustration, the active matrix substrate 25 in use actually has a size matched to the number of pixels of the radiation detector 1.

The detecting elements DU are selected on a row-by-row basis as the gate driver 39 applies fetching power to the gate lines 19 in the X-direction in response to the scan signals in the Y-direction. And with the multiplexer 37 switched by the scan signals in the X-direction, the charges stored in the carrier storage capacitors 13 of the detecting elements DU in the selected rows will be sent out successively through the charge-voltage converter group 35 and multiplexer 37.

Specifically, a radiation detecting operation by the radiation detector 1 in this embodiment is as follows. Upon incidence of radiation to be detected in the state of the bias voltage applied to the common electrode 5 on the front surface of the amorphous semiconductor layer 9, carriers (electron-hole pairs) generated by incidence of the radiation move to the common electrode 5 and picture electrodes 11 due to the bias voltage. Charges corresponding to the number of carriers generated are stored in the carrier storage capacitors 13 adjacent the picture electrodes 11. As the carrier readout switching elements 15 are changed to ON state, the charges stored are read as radiation detection signals via the switching elements 15, to be converted into electric signals by the charge-voltage converter group 35.

Where the radiation detector 1 in this embodiment is used as an X-ray detector of an X-ray fluoroscopic apparatus, for example, after the detection signals of the detecting elements DU are fetched in order as pixel signals from the multiplexer 37, required signal processing such as a noise process is carried out by an image processor 41, and then a two-dimensional image (X-ray fluoroscopic image) is displayed by a pixel display unit 43.

In manufacturing the radiation detector 1 in this embodiment, thin-film transistors for the switching elements 15, carrier storage capacitors 13, picture electrodes 11, carrier selective high resistance film 8, amorphous semiconductor layer 9, carrier selective high resistance film 7 and common electrode 5 are laminated and formed in order on the surface of the insulating substrate 23, using a thin film forming technique by varied vacuum film formation method or a patterning technique by photographic method,

### <<Barrier Layer>>

Reference is made to Figs. 1 and 3. The barrier layer 27 is formed along a quadrilateral outer edge of the common electrode 5, and at least on the upper surface of the carrier selective high resistance film 7 formed on the upper surface of the amorphous semiconductor layer 9. The barrier layer 27, preferably, is formed on the upper surface of the carrier selective high resistance film 7, to be in contact with side surfaces of the common electrode 5 without being spaced from the side surfaces. However, since it is difficult to form the barrier layer in contact with the side surfaces of the common electrode 5 without being spaced from the side surfaces as noted above, the barrier layer 27 is formed also on the upper surface of the common electrode 5 in addition to the upper surface of the carrier selective high resistance film 7. That is, it is formed along the outer edge of the common electrode 5 to bridge the carrier selective high resistance film 7 and common electrode 5. In this embodiment, the barrier layer 27 is formed not to cover the entire surface of the common electrode 5, but to leave an opening in a central portion of the common electrode 5.

The barrier layer 27, preferably, is an insulating material which prevents a chemical reaction between the amorphous semiconductor layer 9 and curable synthetic resin film 29, is adhesive to the curable synthetic resin film 29, and does not chemically react with the amorphous semiconductor layer 9. That is, the barrier layer 27 is formed between the carrier selective high resistance film 7 formed on the upper surface of the amorphous semiconductor layer 9, and the curable synthetic resin film 29, thereby to prevent a chemical reaction between the components of the curable synthetic resin film 29 and upper surface portions of the amorphous semiconductor layer 9 to lower the resistance. The barrier layer 27, preferably, is capable of tight adhesion to the curable synthetic resin film 29. In the case of lacking in adhesiveness, it will be insufficient in strength, such that a repetition of thermal expansion and contraction due to temperature changes causes separation at interfaces between the barrier layer 27 and curable synthetic resin film 29, thereby reducing the effect of inhibiting warpage and cracking. As the material for the barrier layer 27, it is preferred to use what causes no chemical reaction of the amorphous semiconductor layer 9.

Specifically, the barrier layer 27, preferably, is a synthetic resin which does not include an amine material which reacts with the amorphous semiconductor layer 9, thereby reducing the resistance of the surface of the amorphous semiconductor layer 9, that is, a non-amine synthetic resin. As for formation of the barrier layer, formation at a temperature below 40°C is preferred.

Non-amine synthetic resins used for the barrier layer 27 include an acrylic resin, polyurethane resin, polycarbonate resin and synthetic rubber with a non-amine solvent dissolved. The non-amine solvent may be, as used alone or in mixture, toluene, butyl acetate, methyl ethyl ketone, hexahydrotoluene, ethyl cyclohexane, xylene or dichlorobenzene, for example.

As for the thickness of the barrier layer 27, it is preferred that it is at least thicker than the thickness of the carrier selective high resistance film 7. When thinner than the high resistance film 7, there is a possibility that the components of the curable synthetic resin film 29 may permeate the barrier layer 27. The thickness of the barrier layer 27, preferably, is 500µm or less, and more desirably, 100µm or less. When the barrier layer 27 is too thick (when larger than 500µm), it becomes impossible to disregard the thermal expansion stress of the barrier layer 27, and there is a possibility that a problem of separation from other films such as the insulating synthetic resin film may arise. In this embodiment, the thickness of the carrier selective high resistance film 7 is about 1µm.

### <<Experimental result 1>>

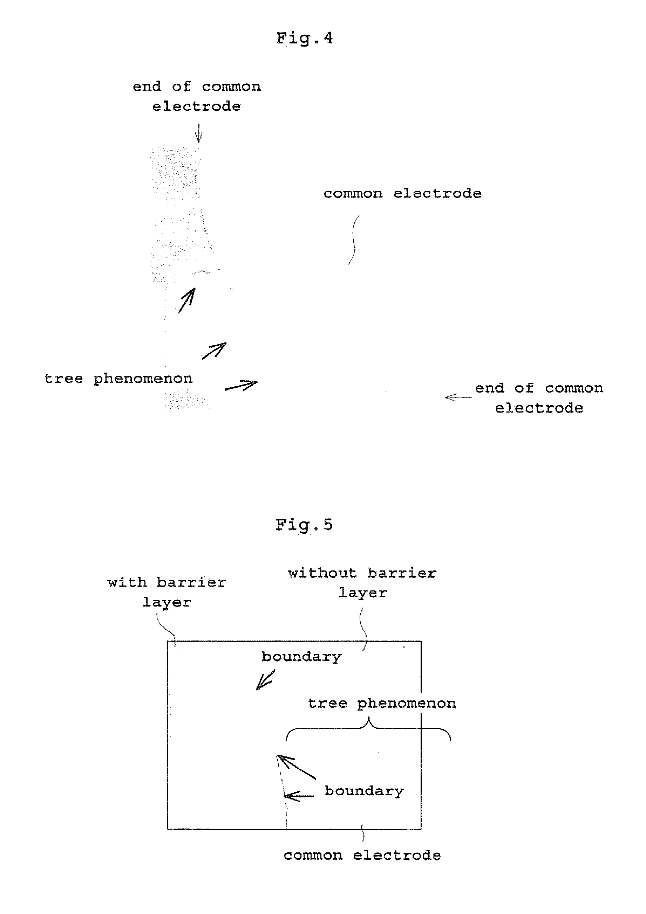

After forming the Sb₂S₃ film (high resistance film 8), a-Se layer (amorphous semiconductor layer 9), Sb₂S₃ film (high resistance film 7) and Au electrode (common electrode 5) in order on the active matrix substrate 25, using a vacuum deposition method, the barrier layer 27 of polyurethane resin was formed in the area as shown in Figs. 1 and 3 by describing and dripping a solution of polyurethane resin diluted with butyl acetate along the outer edge of the Au electrode, using a dispenser method, and drying it at normal temperature below 40°C. Then, the radiation detector 1 of this embodiment was made by putting on top the auxiliary plate 31 formed of glass, and injecting and curing the epoxy resin (curable synthetic resin film 29), through the spacer 33. A conventional radiation detector (Fig. 13) without the barrier layer 27 formed therein was also made for comparison purposes. And an acceleration test was conducted under conditions of 40°C and 14kV, and the outer edge of the Au electrode was observed 84 days after the acceleration test. There was no generation of trees in the radiation detector 1 of this embodiment, but it was confirmed that trees as shown in Fig. 4 generated in the conventional radiation detector. Fig. 5 is a photograph showing a difference in generation of trees at boundaries due to presence or absence of application of the barrier layer 27 of a radiation detector made separately. The effect of the barrier layer 27 can be confirmed by the trees being generated only at the outer edge of the Au electrode which are the non-application portion.

### <<Effect of Embodiment 1>>

The construction of the above radiation detector 1, since the barrier layer 27 is formed on the upper surface of the carrier selective high resistance film 7 along the outer edge of the common electrode 5, can prevent the amine compound which is a component of the insulating synthetic resin film (e.g. epoxy resin) 29 from permeating the carrier selective high resistance film 7 and reacting with the amorphous semiconductor layer 9, thereby to lower the resistance of the amorphous semiconductor layer 9. What is capable of tight adhesion to the curable synthetic resin film 29 is used as the material for forming the barrier layer 27. This can resolve the problem of being insufficient in strength, such that expansion and contraction due to temperature changes cause separation at interfaces between the barrier layer 27 and curable synthetic resin film 29, thereby reducing the effect of inhibiting warpage and cracking. What includes no amine compound that would react with the amorphous semiconductor layer 9 is used as the material for forming the barrier layer 27. This can prevent a reduction of the resistance of the amorphous semiconductor layer 9 which could be caused by the components of the barrier layer 27 permeating the carrier selective high resistance film 7 and reacting with the amorphous semiconductor layer 9. Further, since the material used for forming the barrier layer 27 can cure at normal temperature below 40°C, it can prevent the semiconductor layer from crystallizing and becoming lower in resistance due to the heat occurring at the time of curing of the barrier layer. This can prevent creeping discharge generating from the common electrode 5, thereby to prevent generation of linear noise due to creeping discharge at the outer edge of the common electrode where electric fields concentrate.

Creeping discharge can be prevented as with the radiation detector which, as shown in Fig. 17, has a barrier layer 27E over entire exposed surfaces of the common electrode 5, carrier selective high resistance films 7, 8 and amorphous semiconductor layer 9. However, since the barrier layer 27 is not formed over the entire exposed surfaces as in the radiation detector shown in Fig. 17, the barrier layer 27 can be formed easily, and the material cost of the barrier layer 27 can be held down.

### [EMBODIMENT 2]

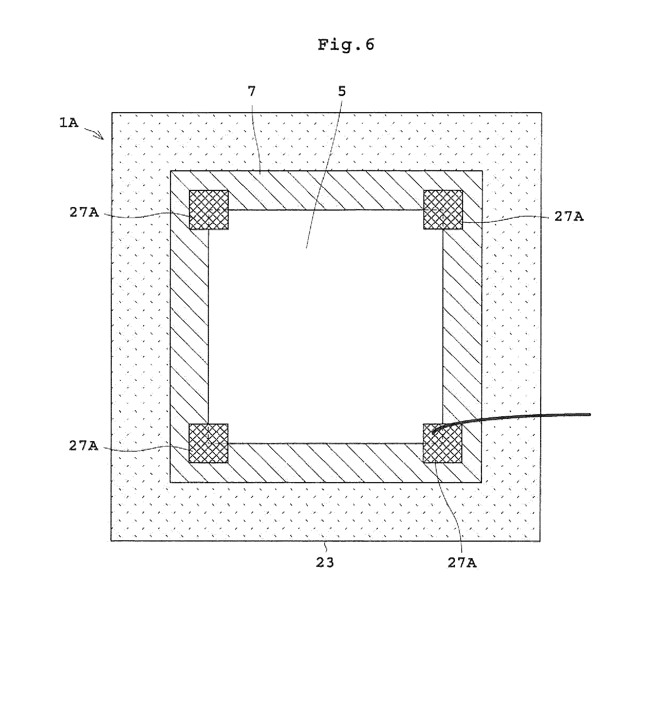

Next, Embodiment 2 of this invention will be described with reference to the drawings. Fig. 6 is a schematic plan view showing a construction of a radiation detector. Description is omitted for the portions overlapping the description of Embodiment 1.

In Embodiment 1, the barrier layer 27 is formed on the upper surface of the carrier selective high resistance film 7 along the outer edge of the common electrode 5. However, the invention is not limited to such construction. For example, since the growth of trees becomes quicker toward the vertexes than the sides of the common electrode 5, barrier layers 27A may be formed on the upper surface of the carrier selective high resistance film 7, in areas limited to vertex portions of the common electrode 5.

Reference is made to Fig. 6. The barrier layers 27A are formed on upper surfaces of areas limited to portions around the vertexes of the common electrode 5, of the areas of formation on the upper surface of the carrier selective high resistance film 7 along the outer edge of the common electrode 5. When the shape of the common electrode 5 is quadrilateral, the barrier layers 27A are formed adjacent the four locations corresponding to the vertexes of the quadrilateral.

### <<Experimental result 2>>

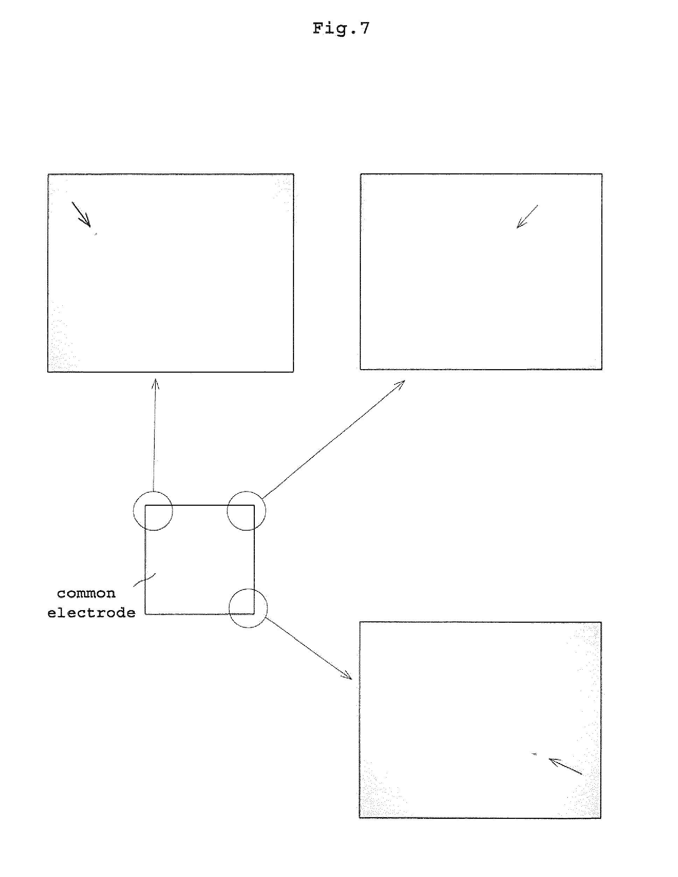

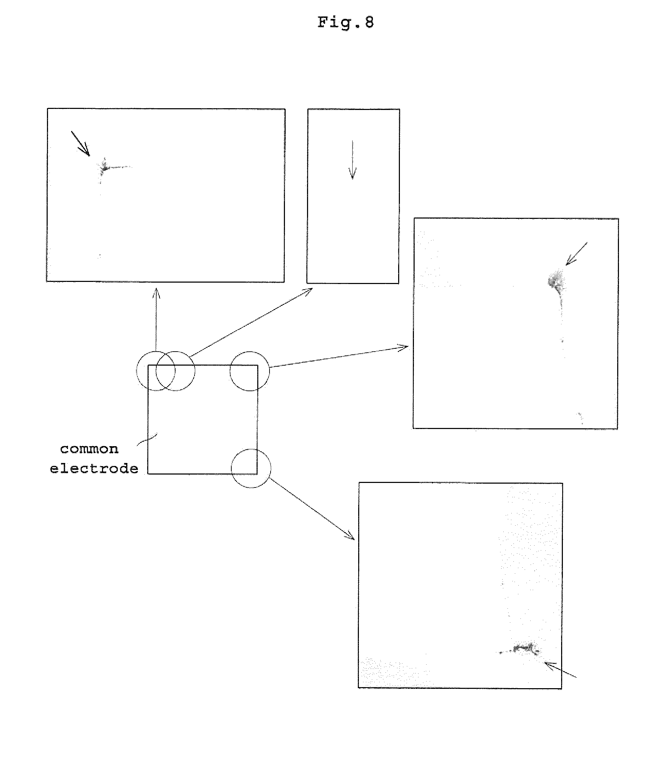

Figs. 7 and 8 are optical micrographs of an outer edge of a common electrode 105 after conducting an acceleration test of the conventional radiation detector without barrier layers as shown in Fig. 13, under conditions of 40°C and 14kV. Fig. 7 shows generation of trees, which are arboroid discharge marks, three days after the acceleration test. It is confirmed that the trees have generated only from the vertex portions of the common electrode 105. Fig. 8 shows generation of the trees 20 days after the acceleration test, and it is confirmed that the trees generated in the vertex portions of the common electrode 105 have grown compared with those three days after the acceleration test shown in Fig. 7. It is confirmed that a tree has generated also at a side of the common electrode 105. Therefore, it has been found that, when the shape of the common electrode 105 is quadrilateral, the growth of trees becomes the quicker from side portions toward the vertex portions.

### <<Effect of Embodiment 2>>

According to the radiation detector 1A having such construction, the greater part of creeping discharge phenomenon can be inhibited by forming the barrier layers 27A only on the vertex portions of the common electrode 5 where electric fields concentrate. Since, as shown in Fig. 6, the formation area of the barrier layers 27A can be further decreased than in Embodiment 1, the barrier layers 27A can be formed more easily, and the material cost of the barrier layers 27A can be further held down.

This invention is not limited to the foregoing embodiments, but may be modified as follows:

(1) In each embodiment described above, the barrier layers 27, 27A are formed by applying a non-amine synthetic resin dissolved with a non-amine solvent, and drying and curing it at a temperature below 40°C. However, this is not limitative. For example, a photo-curable resin may be employed, which forms the barrier layers 27, 27A by being cured by light irradiation such as ultraviolet rays. This can achieve curing without heating, and formation can be attained in a shortened curing time. An acrylic resin blended with mercaptoester is cited as the photo-curable resin.

(2) In each embodiment described above, the barrier layers 27, 27A are formed by describing or continuously applying the material for the barrier layers 27, 27A along the outer edge of the common electrode 5, using a dispenser method. However, this is not limitative. For example, the barrier layers 27, 27A may be formed by coating the above predetermined positions with the non-amine synthetic resin by vacuum deposition method, with portions other than the formation portions being covered with metal masks. In this case, the non-amine synthetic resin, preferably, is poly-para-xylylene.

(3) In each embodiment described above, the shape of the common electrode 5 is quadrilateral, but a common electrode shaped polygonal such as triangular or pentagonal may be employed.

(4) In Embodiment 1 described above, the barrier layer 27 is formed with a similar width on the upper surface of the carrier selective high resistance film 7 along the outer edge of the common electrode 5. However, this is not limitative. The barrier layer 27 may be formed such that, for example, the width of the barrier layer 27 formed on the vertex portions of the common electrode 5 where the tree phenomenon tends to occur is enlarged, and the width of the barrier layer 27 is made smaller on the side portions of the common electrode 5 than on the vertex portions. Although the barrier layer 27 is formed continuously along the outer edge of the common electrode 5, areas without the barrier layer 27 may be provided partly. Although the barrier layer 27 is formed to have an opening in the central part of the common electrode 5, a barrier layer 27 without the opening may be formed.

(5) In each embodiment described above, the vertex portions of the barrier layers 27, 27A are shaped to have corners in plan view, it may be shaped such that the corners are rounded, for example.

(6) In each embodiment described above, the active matrix substrate 25 is employed as matrix substrate, but a passive matrix substrate may be employed.

## Claims

1. A radiation detector comprising:
(a) a radiation sensitive semiconductor layer for generating carriers upon incidence of radiation;
(b) a high resistance film formed to cover an upper surface of the semiconductor layer for selecting and transmitting the carriers;
(c) a common electrode formed on an upper surface of the high resistance film for applying a bias voltage to the high resistance film and the semiconductor layer;
(d) a matrix substrate formed on a lower surface of the semiconductor layer for storing and reading, on a pixel-by-pixel basis, the carriers generated in the semiconductor layer;
(e) a curable synthetic resin film covering entire surfaces of the semiconductor layer, the high resistance film and the common electrode formed on an upper surface of the matrix substrate;
(f) an insulating auxiliary plate disposed opposite the matrix substrate across the curable synthetic resin film, and having a thermal expansion coefficient comparable to that of the matrix substrate; and
(g) a barrier layer formed of an insulating material, which is formed on the upper surface of the high resistance film along an outer edge of the common electrode, prevents a chemical reaction between the semiconductor layer and the curable synthetic resin film, is adhesive to the curable synthetic resin film, and does not chemically react with the semiconductor layer.

2. The radiation detector according to claim 1, wherein:
the common electrode is shaped polygonal; and
the barrier layer is formed on upper surfaces of areas limited to portions around vertexes of the common electrode, of areas of formation on the upper surface of the high resistance film along the outer edge of the common electrode.

3. The radiation detector according to claim 1 or 2, wherein the matrix substrate is an active matrix substrate having picture electrodes for collecting, on a pixel-by-pixel basis, the carriers generated in the semiconductor layer, capacitors for storing charges corresponding to the number of carriers collected by the picture electrodes, switching elements for reading the charges stored, and charge wires arranged in a grid pattern and connected to the switching elements arranged at respective grid points.

4. The radiation detector according to any one of claims 1 to 3, wherein the semiconductor layer is amorphous selenium.

5. The radiation detector according to any one of claims 1 to 4, wherein the curable synthetic resin film is an epoxy resin.

6. The radiation detector according to any one of claims 1 to 5, wherein the barrier layer is thicker than the high resistance film, and an upper limit thereof is 500µm or less.

7. The radiation detector according to any one of claims 1 to 6, wherein the barrier layer is a non-amine synthetic resin not including an amine material.

8. The radiation detector according to claim 7, wherein the barrier layer is a non-amine synthetic resin formed at a temperature below 40°C.

9. The radiation detector according to claim 8, wherein the non-amine synthetic resin is one of an acrylic resin, a polyurethane resin, a polycarbonate resin and synthetic rubber dissolved in a non-amine solvent, and is formed by volatilizing the non-amine solvent at normal temperature.

10. The radiation detector according to claim 9, wherein the non-amine solvent includes at least one of toluene, butyl acetate, methyl ethyl ketone, hexahydrotoluene, ethyl cyclohexane, xylene and dichlorobenzene.

11. The radiation detector according to claim 8, wherein the barrier layer is a photo-curable resin, and is formed by being cured by light irradiation.

12. The radiation detector according to claim 8, wherein the barrier layer is formed by coating the non-amine synthetic resin by vacuum deposition method.

13. The radiation detector according to claim 12, wherein the non-amine synthetic resin is poly-para-xylylene.
